Europäisches Patentamt

European Patent Office

Office européen des brevets

(11) Publication number: 0 276 940
A2

# EUROPEAN PATENT APPLICATION

(21) Application number: 88300399.8

(22) Date of filing: 19.01.88

(51) Int. Cl.⁴: **H 01 L 21/60**
H 01 L 23/48

(30) Priority: 30.01.87 JP 18367/87

(43) Date of publication of application:
03.08.88 Bulletin 88/31

(84) Designated Contracting States: **DE FR GB IT**

(71) Applicant: **HITACHI, LTD.**
**6, Kanda Surugadai 4-chome**
**Chiyoda-ku Tokyo 101 (JP)**

(72) Inventor: **Tanimoto, Michio**
**26-18, Nishi-machi 3-chome**
**Kokubunji-shi Tokyo (JP)**

**Ozawa, Masakazu**
**4-39, Montoh-cho 3-chome**
**Yonezawa-shi Yamagata (JP)**

**Okamoto, Michio**
**1141, Koyama-cho**
**Machida-shi Tokyo (JP)**

**Yasuda, Hajime**
**17-45, Wakaba-cho 4-chome**
**Tachikawa-shi Tokyo (JP)**

(74) Representative: **Calderbank, Thomas Roger et al**
**MEWBURN ELLIS & CO. 2/3 Cursitor Street**
**London EC4A 1BQ (GB)**

The title of the invention has been amended (Guidelines for Examination in the EPO, A-III, 7.3).

(54) **Semiconductor chip having external terminals connected to corresponding leads by wires.**

(57) A resin-encapsulated integrated circuit has a semiconductor chip (2) whose bonding pads (2A) are connected to corresponding leads (3A) by wires (4). In order to achieve the correct interconnection of pads (2A) and leads (3A) some of the wires (4) intersect and to prevent short circuits they are coated in an insulator. This permits great design versatility as the pads and leads may be positioned as desired, rather than having interconnected pads and leads adjacent each other, as is normal.

The use of insulated wires also permits one or more of the bonding pads to be central on the chip rather than at its periphery, and some of the pads may be connected to remote leads.

FIG. 3

**Description**

## A SEMICONDUCTOR DEVICE AND A METHOD OF MANUFACTURING SUCH A DEVICE

The present invention relates to a semiconductor device and a method of manufacturing such a device. It is particularly relevant to the wiring of such a device.

A resin-encapsulated semiconductor device, such as a DILP or an LCC, has an external terminal (bonding pad) of the semiconductor chip and an inner lead connected by a wire. The wire is attached by a ball bonding method or an ultrasonic bonding method. The semiconductor chip, the inner leads and the wire pieces are encapsulated with a resin mold member.

One example of such a resin-encapsulated semiconductor device is described in Extra Number "MICRODEVICES" No. 2 issued June 11, 1984 by Nikkei McGraw-Hill Inc., pp. 82-92.

The inventors of the present invention have studied the resin-encapsulated semiconductor device mentioned above. As a result, they have found that problems occur.

In a resin-encapsulated semiconductor device, the inner leads corresponding to the functions of the external terminals of the semiconductor chip are arranged near these external terminals. By way of example, near the external terminal of the semiconductor chip for a reference voltage e.g. ground (earth) potentials, the lead of the same function for the reference voltage is arranged. With the resin-encapsulated semiconductor device thus constructed, when the arrangement position (the function) of a certain lead is altered, this semiconductor device cannot easily be mounted on a print-wired circuit board. The reason is that the alteration of the arrangement position of the lead necessitates the alteration of the position of the corresponding external terminal of the semiconductor chip and the alteration of the wiring layout, of the input stage circuit and the output stage circuit connected to the semiconductor chip. The alteration of the arrangement position of the lead has become more frequent with the advancement of multikind semiconductor chips and production of small quantities of chips of a particular type. This situation poses the problem that the function of the lead of the resin-encapsulated semiconductor device cannot easily be altered when required.

Also a resin-encapsulated semiconductor device including the semiconductor chip of a microcomputer normally has a timing signal generator circuit arranged at a predetermined peripheral part of the semiconductor chip. The timing signal generator circuit is arranged near an external terminal dedicated thereto. It is constructed so as to deliver the timing signals for various circuits.

Since, however, the timing generator circuit is not arranged at the optimum position, the lengths of wiring lines for connecting the timing generator circuit with the individual circuits are unequal. This poses the problem that shifts develop between the timing signals. Therefore, a circuit for compensating for those shifts of the timing signals may be required.

The present invention seeks to provide a technique capable of easily altering as desired the function of a lead or wiring line in a semiconductor device wherein the external terminal of a semiconductor chip and a lead or the wiring line of a circuit board for mounting the semiconductor chip thereon are connected by a wire. In this way it becomes possible to optimize the arrangement positions of circuits which are formed in the semiconductor chip of the semiconductor device.

The present invention may also permit a reduction in noise which arises in the power source wiring of the semiconductor chip of a semiconductor device.

Of course, in satisfying the above aims, it is important that short-circuiting between the connecting wire pieces and short-circuiting between the semiconductor chip and the wire does not occur.

With the present invention, several improvements in the semiconductor device become possible. For example, it is possible to provide a microcomputer system which can use a system clock of high speed. Furthermore, a gate array IC may be provided which can effectively utilize I/O cells. Also a memory IC may be produced which is free from any supply voltage discrepancy within a chip.

The present invention also relates to a method for manufacturing a semiconductor device, and in particular seeks to provide a wire bonding method which is suited to a coated wire.

Also the present invention may provide:
a resin-encapsulated memory IC device which undergoes little resin cracks and which is small in size;
an assemblage technique for a resin-encapsulated semiconductor device employing a lead frame which is versatile in specification changes;
a resin-encapsulated microcomputer IC device of high design versatility;
a multi-CPU microcomputer system capable of high speed operation; and
a gate array IC (master slice system) capable of utilizing a large number of I/O pins.

A first aspect of the present invention is discussed below.

The external terminals of the semiconductor chip of a semiconductor device and leads or the wiring lines of a circuit board for mounting the semiconductor chip thereon are connected in a state in which a piece of coated wire intersects with another piece of coated wire.

In addition, the predetermined external terminal of the semiconductor chip of a semiconductor device is constructed at the central part of the semiconductor chip, and one end of a coated wire is joined to the external terminal centrally constructed, while the other end of the coated wire is joined to a lead or the wiring line of a circuit board for mounting the semiconductor chip thereon.

According to the above expedient, the functions of the leads or the wiring lines can be easily altered at need without changing the arrangement of the external terminals of the semiconductor chip.

In addition, a circuit, for example, a timing generator circuit to be formed in the semiconductor chip of the semiconductor device is arranged at the optimum position, and the lengths of wiring lines for connecting the timing generator circuit with various circuits can be substantially equalized.

Another aspect of performance of the present invention consists in a semiconductor integrated circuit device comprising:    (a) a semiconductor integrated circuit chip which has first and second principal surfaces;

(b) a large number of bonding pads which are formed on said first principal surface;

(c) a resin mold member in which said chip and said pads are encapsulated;

(d) leads in a large number of 10 to 200, each of whcih includes an inner lead and an outer lead continuous thereto,

said each inner lead lying within said mold member, with said each outer layer protruding from said mold member; and

(e) bonding wires which respectively connect the inner leads of said leads and said pads corresponding thereto,

said wires being encapsulated in said resin mold member;

wherein at least one of said wires is formed with an insulator film over a whole circumference of a substantially full length thereof, and it is wire-bonded so as to intersect at least one of the other wires with respect to an orthogonal projection on said principal surface of said chip.

Still another aspect of performance of the present invention consists in a semiconductor device comprising:    (a) a semiconductor chip which has first and second principal surfaces;

(b) integral logic circuits which occupy a considerable area on said first principal surface of said chip;

(c) bonding pads in a large number of 50 to 200, which are disposed along peripheral sides of said chip,

said large number of pads including a first set, each element of which has a first function, and a second set, each element of which has a second function;

(d) leads ih the large number of 50 to 200, which are so disposed that first ends thereof lie near outer sides of said peripheral sides of said chip;

(e) bonding wires in the large number of 50 to 200, which respectively connect said leads and the corresponding pads; and

(f) a resin mold member which encapsulates said chip, said wires, and said first ends of said leads as well as vicinities thereof;

wherein the first pad set of said first function is arrayed substantially in succession along each side of said chip, and when a small number of elements within the second pad set are inserted in said first pad set, these pads of said second function and the corresponding leads at positions remote therefrom are bonded by pieces of an insulator-coated wire.

Yet another aspect of performance of the present invention consists in a semiconductor integrated circuit microcomputer device comprising:

(a) a first semiconductor chip on which at least one CPU is packaged, and which has first and second principal surfaces, an integrated circuit being formed on said first principal surface;

(b) at least one first bonding pad which is formed on a central or inner zone distant from peripheral sides on said first principal surface of said chip;

(c) second bonding pads in a large number of 10 to 200, which are disposed on said first principal surface of said chip;

(d) leads in the large number of 10 to 200, which are so disposed that first ends thereof lie near said peripheral sides of said chip;

(e) bonding wires in the large number of 10 to 200, which respectively connect said first ends of said leads and the corresponding second pads;

(f) a coated bonding wire which connects any one of said first ends of said leads and the corresponding first pad; and

(g) a resin mold member which encapsulates said chip, said first ends of said leads, said bonding wires, and said coated bonding wire.

A further aspect of performance of the present invention consists in a resin-encapsulated semiconductor integrated circuit microcomputer device including first and second CPU chips within a single resin mold member, comprising:

(a) a system clock generator circuit which is provided on said first CPU chip;

(b) a clock output pad which is disposed on said first CPU chip in order to deliver a clock signal of said system clock generator circuit;

(c) a clock input pad which is disposed on said second CPU chip in order to introduce the system clock; and

(d) a bonding wire which connects said clock output and input pads.

A still further aspect of performance of the present invention consists in a semiconductor integrated circuit memory device comprising:

(a) a memory chip in the shape of a rectangular plate, which has first and second principal surfaces and which has first and second shorter sides and first and second longer sides;

(b) at least one memory mat which occupies substantially a whole central area of said first principal surface of said chip;

(c) a first power source pad corresponding to either of a supply voltage $V_{cc}$ and a reference voltage $V_{ss}$, which is disposed near said first shorter side on said first principal surface of said chip;

(d) a second power source pad corresponding to said either voltage, which is disposed near said second shorter side on said first principal surface of said chip;

(e) a resin mold member which is substantially in the shape of a rectangular parallelepiped of comparatively small height, and in which said chip is encapsulated,

said mold member having first and second opposing principal surfaces and having first and second opposing longer side surfaces and first and second opposing shorter side surfaces, said chip being located substantially centrally of said mold member so that said first principal surface of said chip becomes substantially parallel to said first principal surface of said mold member, that said first longer side of said chip becomes substantially parallel to said first longer side surface of said mold member, and that said first longer side of said chip and said first longer side surface of said mold member lie near to each other over a substantially full length of the former;

(f) a plurality of leads each of which includes an outer lead and an inner lead continuous thereto,

the respective outer leads of said leads protruding from said first longer side surface of said mold member substantially at equal intervals while forming a queue in a longitudinal direction thereof, the respective inner leads of said leads being encapsulated in said mold member; and

(g) at most two pieces of insulator-coated wire through which one of said inner leads is connected to both said first and second power source pads,

said pieces of wire being encapsulated in said resin mold member.

A yet further aspect of performance of the present invention consists in a method of manufacturing a semiconductor device, comprising:     (a) the step of fastening a semiconductor pellet onto a lead frame;

(b) the step of connecting bonding parts of said lead frame and corresponding pads on said pellet by the use of bonding wires;

(c) the step of encapsulating said pellet, said bonding parts of said lead frame and said bonding wires with a resin; and

(d) the step of separating the resin mold member from a body of said lead frame;

wherein those of said bonding wires which are liable to short-circuit at, at least, the resin molding step in case of bonding said bonding wires in accordance with a desired specification without changing a layout of said lead frame are formed of pieces of insulator-coated wire.

In the drawings:

Fig. 1 is a sectional view showing the schematic construction of a resin-encapsulated semiconductor device which is the first embodiment of the present invention;

Fig. 2 is an enlarged sectional view showing the essential portions of the resin-encapsulated semiconductor device;

Fig. 3 is a perspective view of the essential portions of the resin-encapsulated semiconductor device;

Fig. 4 is a plan view of essential portions showing the schematic construction of a resin-encapsulated semiconductor device which is the second embodiment of the present invention;

Fig. 5 is a plan view of essential portions showing the schematic construction of a resin-encapsulated semiconductor device which is the third embodiment of the present invention;

Fig. 6 is a plan view of a gate array IC which is another example of the first embodiment;

Fig. 7 is a plan view of the resin-encapsulated device of a multi-CPU system which is another example of the second embodiment;

Fig. 8 is a plan view of a resin-encapsulated DRAM IC of the tableless type; and

Figs. 9(a) and 9(b) are sectional model diagrams of manufacturing processes which are common to the first to third embodiments.

Now, the construction of the present invention will be described in conjunction with embodiments.

Throughout the drawings, parts having the same functions have identical symbols assigned thereto, and they shall not be repeatedly explained.

[Embodiment I of the Invention]

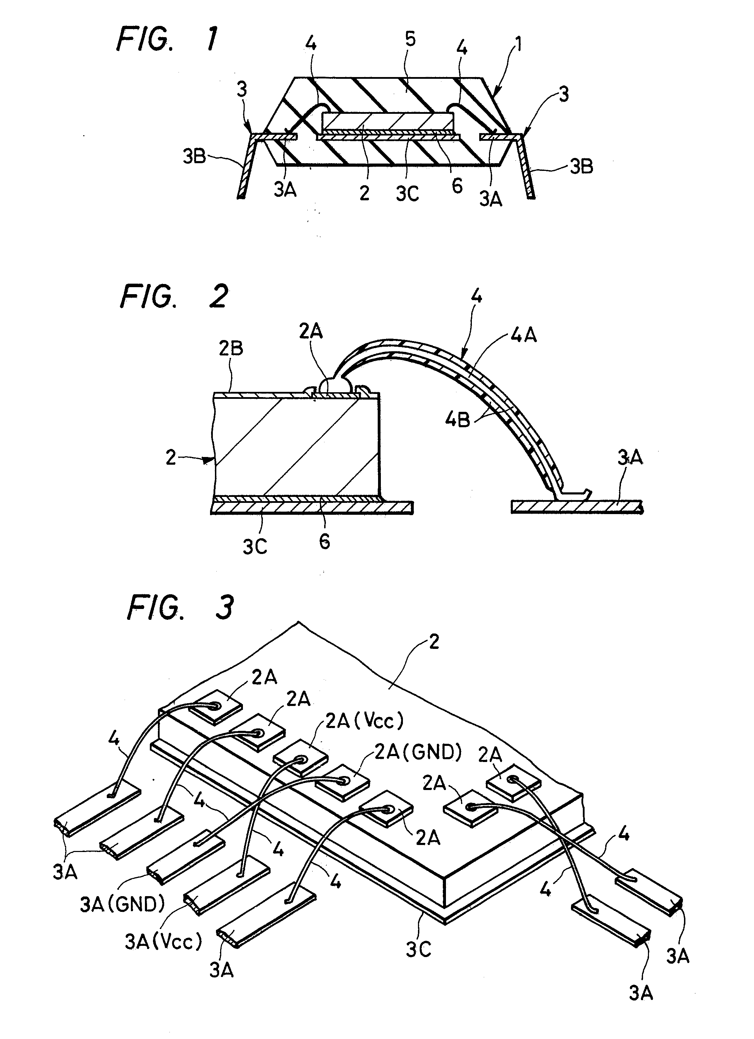

The schematic construction of a resin-encapsulated semiconductor device which is Embodiment I of the present invention is shown in Fig. 1 (a sectional view), while the essential portions of the resin-encapsulated semiconductor device are shown in Fig. 2 (an enlarged sectional view of essential portions in Fig. 1).

As illustrated in Fig. 1, a resin-encapsulated semiconductor device 1 is such that a semiconductor chip (of, for example, Si or GaAs) 2 and the inner lead parts 3A of leads 3 are connected by pieces of coated wire 4 and that they are encapsulated in a resin mold member 5.

As illustrated in Fig. 2, the semiconductor chip 2 is mounted on a tab portion 3C through a connecting metal film (of Au-Si eutectic, Ag paste, or polyimide-based sheet member) 6. One end of the coated wire 4 is joined to an external terminal (bonding pad) 2A which is exposed through the opening of the passivation film 2B of the semiconductor chip 2. The other end of the coated wire 4 is joined to the inner lead part 3A as stated before. The external terminal 2A is formed of, for example, an aluminum film with or without predetermined additives. The outer lead parts 3B of the lead 3 protrude from the resin mold member 5, and are connected by a solder or the like to wiring lines (terminals) formed on a print-wired circuit board.

The coated wire 4 is so configured that the surface of a metal wire 4A is coated with an insulator 4B. The metal wire 4A is made of, for example, gold (Au), copper (Cu) or aluminum (Al). The insulator 4B is made of, for example, an urethane resin, a polyimide resin or a metal oxide film (of CuO, $Cu_2O$ or $Al_2O_3$).

In the resin-encapsulated semiconductor device 1 thus constructed, as illustrated in Fig. 3 (a perspective view of essential portions), the external terminals 2A of the semiconductor chip 2 and the inner lead parts 3A are connected in the state in which some of the pieces of the coated wire 4 intersect the other pieces thereof. Basically, the inner lead parts 3A corresponding to the functions of the external terminals 2A are arranged near these external terminals. In case of altering, for example, the arrangement position (function) of the lead 3 for a reference voltage (a ground potential GND) and the arrangement position (function) of the lead 3 for a supply voltage (the operating potential $V_{cc}$ of circuitry) among the leads, the leads are respectively connected to the external terminal 2A for the supply voltage and that 2A for the reference voltage in the state in which the pieces of the coated wire 4 are intersected. The intersection of the pieces of the coated wire 4 is performed without altering the arrangement positions of the external terminals 2A.

The resin-encapsulated semiconductor device 1 thus constructed can easily alter the arrangement (functions) of the leads 3 at need without changing the arrangement of the external terminals 2A of the semiconductor chip 2. That is, the alteration of the arrangement of the leads 3 requires neither the change of the arrangement of the external terminals 2A of the semiconductor chip 2 nor the change of the layout of wiring lines (aluminum wiring lines), an input stage circuit or an output stage circuit connected to the external terminals 2A.

In the case where the piece of the coated wire 4 is intersected to another piece thereof, both do not short-circuit because the surface of the coated wire 4 is provided with the insulator 4B. Moreover, since the coated wire 4 is provided with the insulator 4B at its surface, it does not short-circuit with the semiconductor chip 2 or the tab portion 3C.

In addition, with the resin-encapsulated semiconductor device 1, the semiconductor chip 2 and the inner lead parts 3A can be sufficiently spaced because the pieces of the coated wire 4 do not short-circuit with the others thereof or the semiconductor chip 2. That is, since the density of the inner lead parts 3A of the leads 3 can be lowered, the number of the leads 3 can be increased to realize more pins of the resin-encapsulated semiconductor device 1.

The above embodiment will be further explained as to an application to a practicable gate array IC.

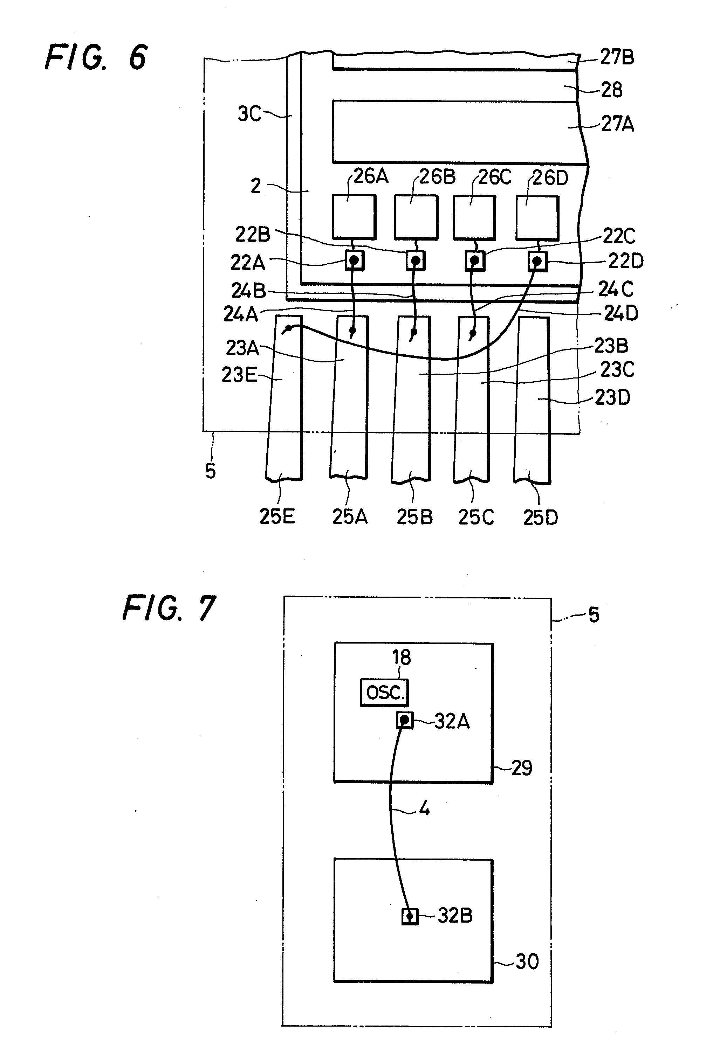

Fig. 6 is a partial schematic plan view of a CMOS gate array IC. Referring to the figure, symbol 3C denotes a tab for die bonding, which is made of a copper alloy and which is patterned as part of a lead frame together with outer leads 25A - 25E as well as inner leads 23A - 23E and by punching or chemical etching from an identical copper sheet. Numeral 2 designates a gate array silicon chip which is fastened on the tab 3C by a die bonding material such as Ag paste, and which is in the shape of a square or rectangular plate being about 10 mm in length and width and 400 μm in thickness. Though not illustratively elucidated here, the leads usually number 200 - 300 or so. Shown at numeral 5 is a resin package which is formed by transfer molding with an epoxy-based thermosetting resin. All bonding pads 22A - 22D are formed by the same layer as Al for internal wiring. Each of the bonding pads is about 100 μm in length and width, and the pitch between the adjacent pads is about 150 μm. Pieces of coated wire 24A - 24D are joined by the so-called "ball wedge bonding." That is, the pad side of the coated wire is subjected to ball bonding, while the inner lead side thereof is subjected to wedge bonding. I/O unit (I/O buffer) cells 26A - 26D are connected to the respective pads 22A - 22D. Symbols 27A and 27B denote macrocells, namely, internal logic cell regions, and numeral 28 indicates a wiring channel region.

Incidentally, the details of gate arrays, especially I/O cells etc. are described in: Takahashi et al GB 2,104,284A and Kawashima, U. S. patent application Serial No. 946,608; filed July 25, 1984. They are quoted, and shall form part of the description.

In this example, the outer leads 25A - 25D are output pins. The pad 22D and the other output pads 22A - 22C are arrayed so as to be respectively connected with the inner leads 23D and 23A - 23C. Since, however, the I/O cell 26D has happened to be determined as an input cell, this pad 22D is connected to the relatively distant input pin 25E by wire bonding. In this manner, even when it has become necessary to dispose a small number of input pads in the middle of the row of a large number of output pads, the pads and the leads can be connected by the use of the coated wire without changing the positions of the outer leads or the shapes of the inner leads.

By the way, the design procedures of gate arrays etc. are described in: DeWitt G. Ong "Modern MOS Technology," McGraw-Hill, 1986; pp. 327 - 331. It is quoted, and shall form part of the description.

[Embodiment II of the Invention]

Embodiment II is another embodiment of the present invention in which the present invention is applied to a resin-encapsulated semiconductor device having a semiconductor chip of microcomputer function.

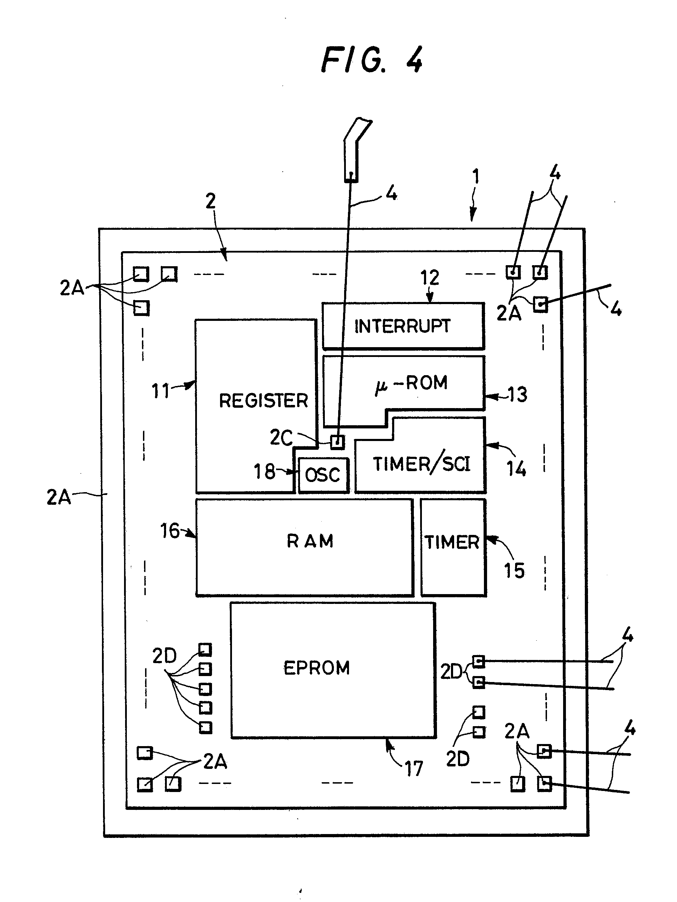

The schematic construction of the resin-encapsulated semiconductor device which is Embodiment II of the present invention is shown in Fig. 4 (a plan view of essential portions).

As illustrated in Fig. 4, the semiconductor chip 2 of the resin-encapsulated semiconductor device 1 of the present embodiment has a microcomputer function. The semiconductor chip 2 is principally constructed of a register (REGISTER) 11, an interrupt (INTERRUPT) 12, a microcode ROM (μ-ROM) 13, a timer and serial communication interface (TIMER/SCI) 14, a timer (TIMER) 15, a RAM (RAM) 16, an EPROM (EPROM) 17, and a timing signal generator circuit (OSC) 18.

The timing signal generator circuit 18 is arranged substantially centrally of the semiconductor chip 2. This timing signal generator circuit 18 is set up so as to be driven by the signal of an external device outside the semiconductor chip 2, for example, a crystal oscillator. It is adapted to generate the timing signals of the various circuits of the semiconductor chip 2. By way of example, it is adapted to generator the timing signals of the decoder circuit and data output circuit of each of the microcode ROM 13, the RAM 16 and the EPROM 17.

The timing signal generator circuit 18 is connected with the external device in such a way that an external terminal 2C provided near this generator circuit, namely, at the central part of the semiconductor chip 2 and the inner lead part 3A of a lead 3 are connected by a piece of coated wire 4. This piece of the coated wire 4 for connecting the external terminal 2C and the inner lead part 3A does not short-circuit with any other piece of the coated wire 4, any of external terminals 2A or any other circuit part.

In this manner, in the resin-encapsulated semiconductor device 1, the external terminal 2C of the timing signal generator circuit 18 is constructed centrally of the semiconductor chip 2, and one end of the coated wire 4 is joined to the external terminal 2C centrally constructed, while the other end of the coated wire 4 is joined to the inner lead part 3A, whereby the timing signal generator circuit 18 can be arranged at the optimum position to substantially equalize the lengths of wiring lines (for example, aluminum wiring lines) for connecting this timing signal generator circuit 18 and the respective circuits. That is, the timing signals to enter the various circuits do not shift, or circuits for compensating the shifts of the timing signals are not required.

Moreover, according to the present invention, as illustrated on the lower side of Fig. 4, external terminals 2D arranged at the peripheral parts of the semiconductor chip 2 inside the external terminals 2A while confronting these external terminals 2A can be connected with the inner lead parts 3A by pieces of the coated wire 4 without short-circuiting to pieces of the coated wire 4 for connecting the external terminals 2A and the inner lead parts 3A.

Further, another example of application to a microcomputer system will be described.

Fig. 7 is a schematic plan view of a multi-CPU system. Referring to the figure, this system comprises a main CPU 29, a sub CPU 30, a timing clock generator 18 with an external output pad 32A, an external clock input pad 32B, a piece of coated wire 4, and a resin package 5 for encapsulating all the aforementioned constituents.

In this case, the main and sub CPU's need to operate at the same timings. Accordingly, clock pulses generated by the clock generator 18 are distributed to the various circuits of the main CPU 29 and are simultaneously fed to peripheral IC's outside the microcomputer system through ordinary peripheral pads, while they are fed from the clock outputting central pad 32A through the coated wire 4 to the external clock input pad 32B of the sub CPU 30 and then to the various circuits of the sub CPU 30 (all the sub CPU's).

Thus, in the multi-CPU system, the system clock can be fed without delay in the identical chip, and the delay of the system clock in the other CPU chip (or chips) can be minimized.

Incidentally, concrete matters on microcomputers are described in: Kurakazu et al, U. S. Patent Application Serial No. 640,465, filed August 13, 1984, and Tsuchiya et al, U. S. Patent Application Serial No. 802,198, filed November 25, 1985. They are quoted, and shall form part of the description.

Further, problems on the clock generator and system clock of a microcomputer are described in: Osborne "An Introduction to Microcomputers: Volume 1 - Basic Concepts, Second Edition," McGraw-Hill, 1980, p. 4-17 to p. 4-24; a multi-CPU system is described in: Christopher L. Morgan and Mitchell Waite "8086/8088 16-bit Microprocessor Primer," McGraw-Hill, 1982, pp. 323 - 338; and the architectures of microcomputers and the functions of various circuit blocks are described in: Harry Garland "Introduction to Microprocessor system design," McGraw-Hill, 1979, pp. 35 - 57. They are quoted, and shall form part of the description.

[Embodiment III of the Invention]

Embodiment III is another embodiment of the present invention capable of reducing noise which develops in the power source wiring of the semiconductor chip of a resin-encapsulated semiconductor device.

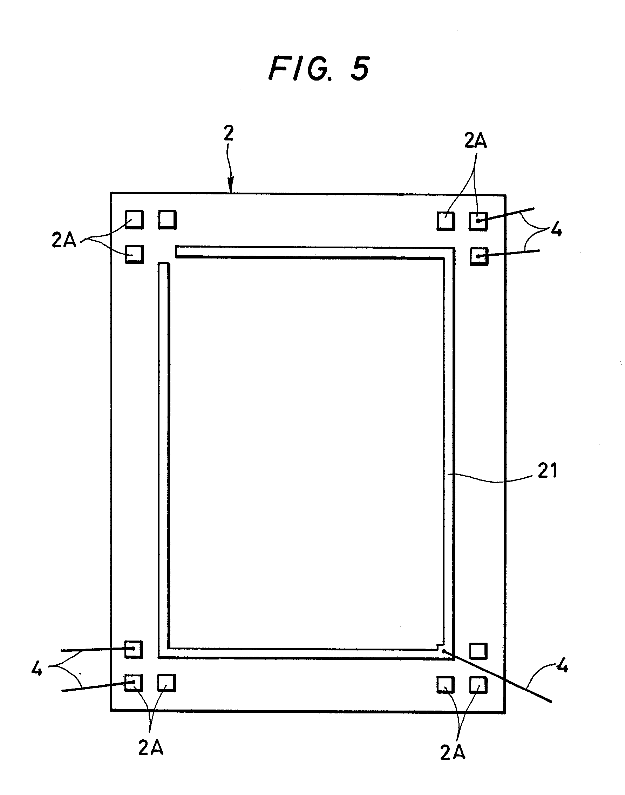

The schematic construction of the resin-encapsulated semiconductor device which is Embodiment III of the present invention is shown in Fig. 5 (a plan view of essential portions).

As illustrated in Fig. 5, power source wiring 21 extends at the peripheral part of the semiconductor chip 2 of a resin-encapsulated semiconductor device 1. Though not shown in detail, the power source wiring 21 is constructed of a power source wiring line for a reference voltage and a power source wiring line for a supply voltage. This power source wiring 21 is so schemed as to provide the reference voltage and supply voltage of internal circuits, or an input stage circuit and an output stage circuit (buffer circuit) disposed at the peripheral part of the semiconductor chip 2. A piece of coated wire 4 which is bonded with an inner lead part 3A for the supply voltage is joined to the middle part of the extending area of the power source wiring 21.

By joining the coated wire 4 to the middle part of the power source wiring 21 in this manner, a noise extracting path can be shortened, so that the noise developing on the power source wiring 21 can be immediately reduced.

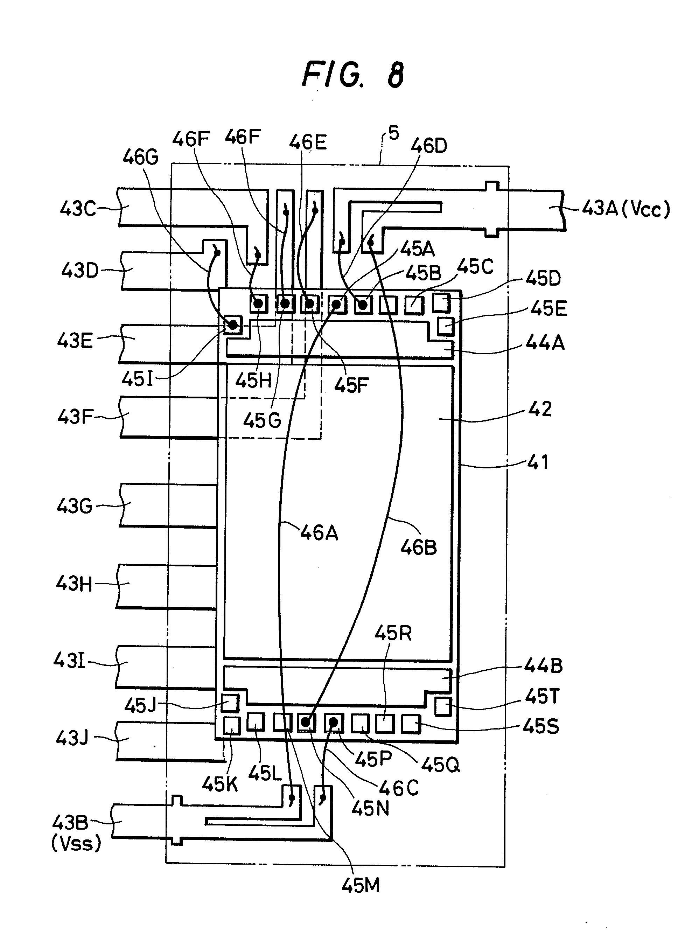

An important example of application relevant to this embodiment will now be explained. Fig. 8 is a schematic plan view of a 4-Mbit DRAM resin mold package (of the SOP type). Referring to the figure, numeral 5 designates a transfer mold member made of an epoxy resin, numeral 41 a Si chip, and numeral 42 a memory mat. Symbols 43A - 43J denotes some of the leads of the package as made from a Cu alloy sheet. Among these leads, the lead 43A serves as a supply voltage $V_{cc}$ terminal, and the lead 43B serves as a reference voltage $V_{ss}$ (Gnd) terminal. The pellet 41 has its rear surface insulatedly fastened on the large number of leads through a polyimide sheet (the so-called tabless resin mold structure). Shown at symbols 44A and 44B are peripheral circuits. Symbols 45A - 45T indicate Al bonding pads, among which the pads 45B and 45N are $V_{cc}$ terminals, and the pads 45A and 45P are $V_{ss}$ (Gnd) terminals. Symbols 46A - 46G indicate pieces of coated wire, and for the sake of brevity, such wire pieces between some of the pads and the corresponding inner leads are omitted from illustration.

In DRAM's referred to here, the longer sides of the chip 41 are as long as about 15 mm, and the rear surface of the chip is insulated from the leads, so that discrepancies in the power source voltages arise on the front surface of the chip. This problem, however, can be solved without taking any circuit-wise countermeasure, in such a way that as illustrated in Fig. 8, the $V_{cc}$ and $V_{ss}$ pads are disposed at each of both the ends of the chip and are respectively bonded with the pieces of the coated wire.

Incidentally, the problems of the discrepancies of power source voltages are described in: Moyer, USP 4,612,564 (U. S. Patent Application No. 616,823, filed June 4, 1984); pre-processing of general DRAM's is described in: Shimizu et al, USP 4,612,565; and a package of the so-called tabless type is described in: Okinaga et al, U. S. Patent Application Serial No. 845,332, filed March 21, 1986. They are quoted, and shall form part of the description.

[Details of Assemblage Process applied to Embodiments I - III in common]

The wire bonding in the foregoing embodiments is carried out using fine wire which has a diameter of 30 μm and which is made of copper (such as tough-pitch copper), aluminum, gold or the like. It will now be described in detail.

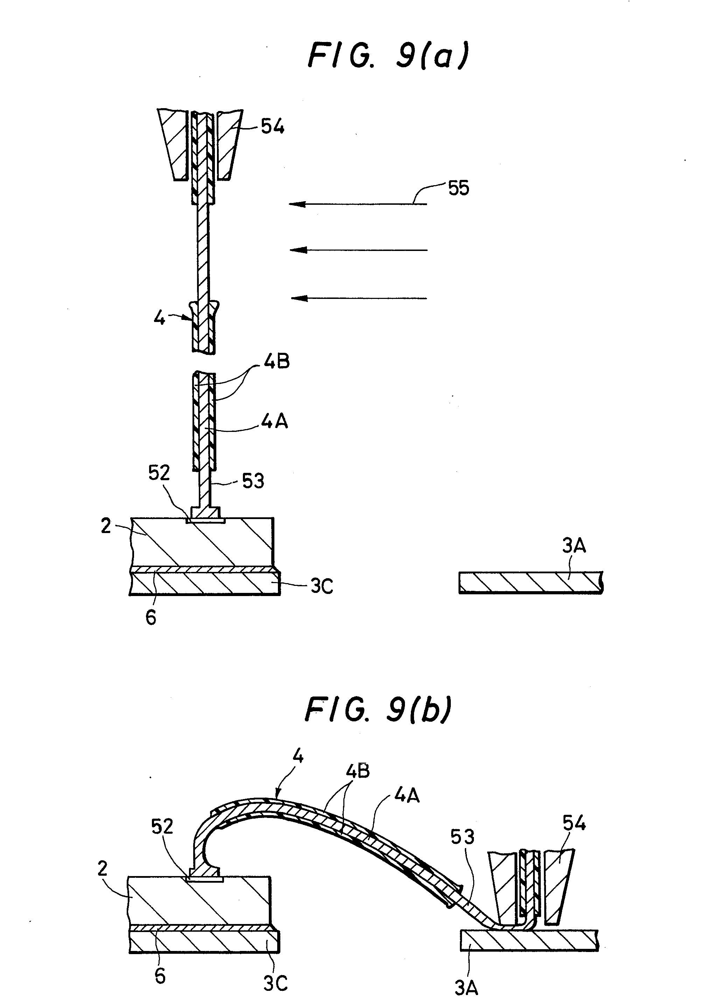

Figs. 9(a) and 9(b) show the outline of the flow of a wire bonding process. Here will be chiefly explained a case where the copper wire is applied to Embodiment 1. Naturally, the Au (gold) wire or the Al (aluminum) wire can be employed.

Though not especially restricted, the semiconductor device of this example is finished up in such a way that a semiconductor pellet 2 made of silicon single crystal is mounted by an Ag paste 6 on the tab 3C of a lead frame made of a copper alloy, that bonding pads serving as the electrodes of the pellet 2 and inner lead parts 3A serving as external terminals are electrically connected through bonding wires 4, and that the pellet 2, the bonding wires 4, the tab 3C of the lead frame, and the inner lead parts 3A are encapsulated by a transfer molding method employing a molding resin (5 in Fig. 1).

In the semiconductor device of this example, as illustrated in Figs. 9(a) and 9(b), the wire 4 which connects the bonding pad 52 of the pellet 2 and the inner lead part 3A of a lead is formed of copper 4A at a purity of at least 99.99 weight-%, and the surface thereof except the vicinities of bonding parts is perviously coated with a resin layer 4B made of an urethane resin.

Though not especially restricted, the bonding of the wire 4 to the bonding pad 52 of the semiconductor pellet 2 is performed by the so-called ball bonding (ball wedge bonding).

The bonding wire 4 is coated with the insulating urethane resin. Therefore, even if a wire touch in which this wire 4 comes into contact with, e. g., another wire or the corner of the pellet arises after the end of the bonding, the occurrence of a defect ascribable to short-circuiting can be effectively prevented.

The wire bonding as stated above can be conducted by various methods.

By way of example, at the first step, the front end of the wire 4 exposed from the front end of a capillary 54 is formed with a ball by electrospark machining the atmosphere of which is a non-oxidizing atmosphere consisting of, e. g., argon and hydrogen (not illustrated). On this occasion, the coating resin at the front end of the wire 4 is removed. Secondly, as illustrated in Fig. 9(a), the wire 4 is ball-bonded to the bonding pad 52, whereupon the capillary 54 being a bonding tool is raised to a predetermined position at which the predetermined part of the wire 4 is irradiated with a laser beam 55 as indicated by arrows, thereby to melt and remove the resin layer 4B and to denude copper 53.

Subsequently, the position of the capillary 54 is lowered to the denuded part of the copper 53, whereupon the capillary 54 is moved to over the inner lead part 3A and then caused to descend, whereby the wedge bonding between the wire 4 and the inner lead part 3A is effected. Thereafter, the wire 4 is drawn up to be thus cut. After the cutting, the front end of the wire 4 is formed with a ball again so as to make ready for the next bonding. Incidentally, the ball may well be formed in such a way that the denuded part of the wire is heated and melted by an electric torch or the like. In the above bonding, a thermocompression bonding technique utilizing ultrasonic vibrations is employed in order to ensure the bonding.

By the way, the transfer molding process is described in: S. M. Sze "VLSI Technology," McGraw-Hill, 1983, pp. 574 - 581; and the ball wedge bonding, etc. (with Au wire) are described in the same book, pp. 555 - 559. They are quoted, and shall form part of the description.

With such a method, the wire bonding can be readily accomplished in conformity with the conventional ball bonding by the use of the wire which is coated with the resin layer beforehand.

Although, in the above, the invention made by the inventors has been concretely described in conjunction with the embodiments, it is a matter of course that the present invention is not re stricted to the foregoing embodiment, but that it can be variously modified within a scope not departing from the purpose thereof.

By way of example, the present invention is applicable to a ceramics-encapsulated semiconductor device in which the external terminals of a semiconductor chip and leads are connected.

In addition, the present invention is applicable to a semiconductor device in which a plurality of semiconductor chips are mounted on a semiconductor chip-mounting board (mother board), whereupon the external terminals of the semiconductor chips and the wiring lines (terminals) of the semiconductor chip-mounting board are connected by wires.

Effects which can be attained by the typical aspects of performance of the present invention will be briefly explained below:

The functions of the leads or wiring lines of a semiconductor device can be easily altered at need.

Moreover, a circuit to be formed in the semiconductor chip of a semiconductor device, for example, a timing signal generator circuit can be arranged at the optimum position to substantially equalize the lengths of wiring lines for connecting the timing signal generator circuit and various circuits.

## Claims

1. A semiconductor device having external terminals of a semiconductor chip and leads or wiring lines formed on a circuit board for mounting the semiconductor chip thereon are connected by wires; wherein the wires are metal coated with an insulator, the external terminals of the semiconductor chip and the leads or the wiring lines are connected such that at least one of the wires intersects an adjacent wire.

2. A semiconductor device according to claim 1, in which the wires intersect so that the function of the lead or the wiring line can be altered without changing the arrangement of the external terminals of the semiconductor chip.

3. A semiconductor device having external terminals of a semiconductor chip and leads or wiring lines formed on a circuit board for mounting the semiconductor chip thereon are connected by wires; wherein a predetermined one of said external terminals is constructed at a central part of said semiconductor chip, that said wires are pieces of a coated wire in which a surface of a metal wire is coated with an insulator, and that one end of a piece of said coated wire is joined to said external terminal constructed centrally of said semiconductor chip, while the other end thereof is joined to the lead or the wiring line.

4. A semiconductor device as defined in Claim 3, characterized in that said semiconductor chip constructs a microcomputer, and that said external terminal arranged centrally is an external terminal which is connected to a timing generator circuit.

5. A semiconductor integrated circuit device comprising:

(a) a semiconductor integrated circuit chip which has first and second principal surfaces;

(b) a large number of bonding pads which are formed on said first principal surface;

(c) a resin mold member in which said chip and said pads are encapsulated;

(d) leads in a large number of at least 10 to 200, each of which includes an inner lead and an outer lead continuous thereto,

said each inner lead lying within said mold member, with said each outer lead protruding from said mold member; and

(e) bonding wires which respectively connect the inner leads of said leads and said pads corresponding thereto,

said wires being encapsulated in said resin mold member;

wherein at least one of said wires is formed with an insulator film over a whole circumference of a substantially full length thereof, and it is wire-bonded so as to intersect at least one of the other wires with respect to an orthogonal projection on said principal surface of said chip.

6. A semiconductor integrated circuit device as defined in Claim 5, wherein each of the other wires is formed with an insulator film over a whole circumference of a substantially full length thereof.

7. A semiconductor integrated circuit device as defined in Claim 6, wherein each of the large number of wires is subjected to ball wedge bonding.

8. A semiconductor integrated circuit device as defined in Claim 7, wherein said mold member is formed by transfer molding.

9. A semiconductor integrated circuit device as defined in Claim 8, wherein said insulator film as a coating of said each wire is removed at and near a part of said wire to be connected to the corresponding lead or pad, during a bonding process.

10. A semiconductor integrated circuit device as defined in Claim 9, wherein said coating consists principally of an organic resin.

11. A semiconductor device comprising:

(a) a semiconductor chip which has first and second principal surfaces;

(b) internal logic circuits which occupy a considerable area on said first principal surface of said chip;

(c) bonding pads in a large number of at least 50 to 200, which are disposed along peripheral sides of said chip,

said large number of pads including a first set, each element of which has a first function, and a second set, each element of which has a second function;

(d) leads in the large number of at least 50 to 200, which are so disposed that first ends thereof lie near outer sides of said peripheral sides of said chip;

(e) bonding wires in the large number of at least 50 to 200, which respectively connect said leads and the corresponding pads; and

(f) a resin mold member which encapsulates said chip, said wires, and said first ends of said leads as well as vicinities thereof;

wherein the first pad set of said first function is arrayed substantially in succession along each side of said chip, and when a small number of elements within the second pad set are inserted in said first pad set, these pads of said second function and the corresponding leads at positions remote therfrom are bonded by pieces of an insulator-coated wire.

12. A semiconductor device as defined in Claim 11, wherein said chip constructs a gate array IC.

13. A semiconductor device as defined in Claim 12, wherein each of said pads of said first function is one of an output pad and an input pad, while each of said pads of said second function is the other of them.

14. A semiconductor device as defined in Claim 13, wherein said resin mold member is formed by transfer molding.

15. A semiconductor integrated circuit microcomputer device comprising:

(a) a first semiconductor chip on which at least one CPU is packaged, and which has first and second principal surfaces, an integrated circuit being formed on said first principal surface;

(b) at least one first bonding pad which is formed on a central or inner zone distant from peripheral sides on said first principal surface of said chip;

(c) second bonding pads in a large number of at least 10 to 200, which are disposed on said first principal surface of said chip;

(d) leads in the large number of at least 10 to 200, which are so disposed that first ends thereof lie near said peripheral sides of said chip;

(e) bonding wires in the large number of at least 10 to 200, which respectively connect said first ends of said leads and the corresponding second pads;

(f) a coating bonding wire which connects any one of said first ends of said leads and the corresponding first pad; and

(g) a resin mold member which encapsulates said chip, said first ends of said leads, said bonding wires, and said coated bonding wire.

16. A semiconductor integrated circuit microcomputer device as defined in Claim 15, wherein said mold member is formed by transfer molding.

17. A semiconductor integrated circuit microcomputer device as defined in Claim 16, wherein said first pad is an output terminal for clock pulses from a clock pulse generator circuit.

18. A semiconductor integrated circuit microcomputer device as defined in Claim 17, wherein said coated wire has an insulator film which extends substantially a whole surface thereof except bonding parts thereof.

19. A semiconductor integrated circuit microcomputer device as defined in Claim 18, wherein said bonding parts having been coated with the insulator film have said insulator film removed therefrom during a bonding process.

20. A resin-encapsulated semiconductor integrated circuit microcomputer device including first and second CPU chips within a single resin mold member, comprising:

(a) a system clock generator circuit which is provided on said first CPU chip;

(b) a clock output pad which is disposed on said first CPU chip in order to deliver a clock signal of said system clock generator circuit;

(c) a clock input pad which is disposed on said second CPU chip in order to introduce the system clock; and

(d) a bonding wire which connects said clock output and input pads.

21. A resin-encapsulated semiconductor integrated circuit microcomputer device as defined in Claim 20, wherein said wire is an insulator-coated wire.

22. A resin-encapsulated semiconductor integrated circuit microcomputer device as defined in Claim 21, wherein said wire is joined to said output pad on said first CPU chip by ball bonding and is joined to said input pad on said second CPU chip by wedge bonding.

23. A semiconductor integrated circuit memory device comprising:

(a) a memory chip in the shape of a rectangular plate, which has first and second principal surfaces and which has first and second shorter sides and first and second longer sides;

(b) at least one memory mat which occupies substantially a whole central area of said first principal surface of said chip;

(c) a first power source pad corresponding to either of a supply voltage $V_{cc}$ and a reference voltage $V_{ss}$, which is disposed near said first shorter side on said first principal surface of said chip;

(d) a second power source pad corresponding to said either voltage, which is disposed near said second shorter side on said first principal surface of said chip;

(e) a resin mold member which is substantially in the shape of a rectangular parallelepiped of comparatively small height, and in which said chip is encapsulated,

said mold member having first and second opposing principal surfaces and having first and second opposing longer side surfaces and first and second opposing shorter side surfaces, said chip being located substantially centrally of said mold member so that said first principal surface of said chip becomes substantially parallel to said first principal surface of said mold member, that said first longer side of said chip becomes substantially parallel to said first longer side surface of said mold member, and that said first longer side of said chip and said first longer side surface of said mold member lie near to each other over a substantially full length of the former;

(f) a plurality of leads each of which includes an outer lead and an inner lead continuous thereto,

the respective outer leads of said leads protruding from said first longer side surface of said mold member substantially at equal intervals while forming a queue in a longitudinal direction thereof, the respective inner leads of said leads being encapsulated in said mold member; and

(g) at most two pieces of insulator-coated wire through which one of said inner leads is connected to both said first and second power source pads,
said pieces of wire being encapsulated in said resin mold member.

24. A semiconductor integrated circuit memory device as defined in Claim 23, wherein said chip is not underlaid with a single tab of large area for fastening said chip thereon.

25. A semiconductor integrated circuit memory device as defined in Claim 24, wherein said chip has said second principal surface thereof fastened on the plurality of inner leads through an insulator film member.

26. A semiconductor integrated circuit memory device as defined in Claim 23, wherein said chip is a DRAM chip.

27. A semiconductor integrated circuit memory device as defined in Claim 23, wherein said one inner lead is branched at its inner end, and said at most two pieces of coated wire are bonded at the branched end parts.

28. A semiconductor integrated circuit memory device as defined in Claim 23, wherein said resin mold member is formed by transfer molding.

29. A method of manufacturing a semiconductor device, comprising:

(a) the step of fastening a semiconductor pellet onto a lead frame;

(b) the step of connecting bonding parts of said lead frame and corresponding pads on said pellet by the use of bonding wires;

(c) the step of encapsulating said pellet, said bonding parts of said lead frame and said bonding wires with a resin; and

(d) the step of separating the resin mold member from a body of said lead frame;

wherein those of said bonding wires which are liable to short-circuit at, at least, the resin molding step in case of bonding said bonding wires in accordance with a desired specification without changing a layout of said lead frame are formed of pieces of insulator-coated wire.

30. A method of manufacturing a semiconductor device as defined in Claim 29, wherein all of said bonding wires are of said insulator-coated wire.

31. A method of manufacturing a semiconductor device as defined in Claim 30, wherein said pellet constructs a gate array.

32. A method of manufacturing a semiconductor device as defined in Claim 30, wherein each of said bonding wires is formed with an organic coating over its full length in advance, and parts of said coating corresponding to bonding points are removed during the bonding step.

33. A method of manufacturing a semiconductor device as defined in Claim 32, wherein said pellet constructs a CPU of a microcomputer.

34. A method of manufacturing a semiconductor device as defined in Claim 32, wherein said pellet constructs a DRAM chip.

35. A method of manufacturing a semiconductor device as defined in Claim 32, wherein said bonding wires consist essentially of copper.

0276940

FIG. 1

FIG. 2

FIG. 3

0276940

## FIG. 4

## FIG. 5

0276940

FIG. 6

FIG. 7

0276940

## FIG. 8

0276940

## FIG. 9(a)

## FIG. 9(b)